**Europäisches Patentamt**

**European Patent Office**

**Office européen des brevets**

(19)

(11) Veröffentlichungsnummer : **0 296 311 B2**

(12)

# NEUE EUROPÄISCHE PATENTSCHRIFT

(45) Veröffentlichungstag der neuen Patentschrift :
24.05.95 Patentblatt 95/21

(51) Int. Cl.$^6$ : **H03L 7/22**

(21) Anmeldenummer : **88102779.1**

(22) Anmeldetag : **25.02.88**

(54) **Oszillatoreinrichtung zur Erzeugung von wenigstens zwei unterschiedlichen Frequenzen.**

(30) Priorität : **23.06.87 DE 3720682**

(43) Veröffentlichungstag der Anmeldung :
**28.12.88 Patentblatt 88/52**

(45) Bekanntmachung des Hinweises auf die
Patenterteilung :
**15.04.92 Patentblatt 92/16**

(45) Bekanntmachung des Hinweises auf die
Entscheidung über den Einspruch :
**24.05.95 Patentblatt 95/21**

(84) Benannte Vertragsstaaten :
**AT BE CH DE ES FR GB GR IT LI LU NL SE**

(56) Entgegenhaltungen :
**EP-A- 0 206 247
DE-A- 3 046 486
GB-A- 2 113 493
US-A- 3 413 565**

(56) Entgegenhaltungen :
**US-A- 3 962 653
ELEKTRONIK, Band 31, Nr. 1, 15. Januar 1982,
Seiten 69-70, München, DE; C. KONECNY:
"Erzeugung mehrerer phasengekoppelter
Rechteckschwingungen"
Grundig Technische Informationen, 1/79, S.
20-24: "Synthesizerabstimmung nach dem
PLL-System mit hoher Auflösung"**

(73) Patentinhaber : **HAGENUK GMBH
Westring 431
D-24118 Kiel (DE)**

(72) Erfinder : **Schenk, Jörg
Wakenitzstrasse 8
D-2313 Raisdorf (DE)**

(74) Vertreter : **Hansmann, Dierk, Dipl.-Ing.
Patentanwälte
Hansmann-Klickow-Hansmann
Jessenstrasse 4
D-22767 Hamburg (DE)**

EP 0 296 311 B2

## Beschreibung

Die Erfindung betrifft eine Oszillatoreinrichtung zur Erzeugung von wenigstens zwei unterschiedlichen Frequenzen mit wenigstens zwei getrennten Phasenregelkreisen PLL und jeweils mit den Phasenregelkreisen in Regelschleifen verbundenen abstimmbaren Oszillatoren VCO, wobei

- ein aus einer festen Referenzfrequenz durch Frequenzteilung erzeugtes Referenzsignal Phasendetektoren der Phasenregelkreise zugeführt wird, und
- das von den mit den abstimmbaren Oszillatoren VCO verbundenen Teilern der Phasenregelkreise PLL erzeugte Teilungsverhältnis der von den abstimmbaren Oszillatoren VCO gelieferten Signale vorbestimmter Frequenz derart einstellbar ist, daß das Teilungsverhältnis n des einen Teilers zum Teilungsverhältnis $n_1$ des anderen Teilers in folgendem Zusammenhang steht:

$$n = n_1 + n_2,$$

wobei $n_2$ die Differenz der von den abstimmbaren Oszillatoren gelieferten Frequenzen bestimmt.

Oszillatoreinrichtungen dieser Art sind bekannt und werden im allgemeinen mit Synthesizeroszillatoren bezeichnet. Derartige Oszillatoreinrichtungen bzw. Synthesizer sind vom Prinzip her Generatoren, die ihre in Stufen einstellbare Ausgangsfrequenz von einer festen Referenzfrequenz ableiten. Damit steht die Ausgangsfrequenz eines Synthesizers in einem festen Verhältnis zur Frequenz seiner Referenzquelle. Die Frequenzkonstanz der Referenzquelle bestimmt die Frequenzkonstanz und Einstellgenauigkeit des Synthesizers. Ein Synthesizer verbindet die Vorteile eines abstimmbaren Oszillator mit den Eigenschaften seiner Referenzquelle (beispielsweise temperaturkompensierter Quarzoszillator bzw. Quarzoszillator mit Thermostat als Referenzoszillator).

Aufgrund dieser Eigenschaften werden Synthesizer dieser Art in Empfängern und Sendern eingesetzt. Werden in Empfängern und Sendern mehrere Frequenzen benötigt, können diese aus dem vorerwähnten Referenzoszillator mittels der vorgenannten Synthesizer, die in der Regel PLL-Schaltungen aufweisen, abgeleitet werden. Wie schon erwähnt, bestimmt die Genauigkeit des Referenzoszillators die Genauigkeit der einzelnen davon abgeleiteten Frequenzen. Mehrstufig ausgebaute Sender bzw. Empfänger weisen in der Regel eine Mehrzahl unterschiedlicher Mischerfrequenzen auf, so daß in Empfängern und Sendern in der Regel zwei oder mehr Oszillatorfrequenzen benötigt werden.

Werden beispielsweise zwei Frequenzen benötigt, die in einem festen Raster veränderlich sein sollen und dabei eine bestimmte feste Differenz in bezug auf ihre Frequenz aufweisen sollen, so wurden bisher zwei PLL-Schaltungen (Phased Locked Loop) im Synthesizer benutzt, die von einem gemeinsamen Referenzsignal angesteuert, d. h. mit einer gemeinsamen Referenzfrequenz versorgt werden.

Faktisch bedeutet das, daß bis auf den Referenzoszillator für jede zu erzeugende Frequenz ein vollständiger Regelkreis, bestehend aus Phasenregelkreis PLL, abstimmbaren Oszillator VCO sowie aus einem Vorteiler aufgebaut werden muß, der die vom abstimmbaren Oszillator VCO gelieferte Frequenz zum Vergleich im Phasenregelkreis PLL unterteilt. Es ist offensichtlich, daß es nachteilig ist, daß für jede Frequenz ein vollständiger Aufbau mit allen Komponenten derartiger Regelkreise nötig ist, da das zwangsweise mit einer erhöhten Stromaufnahme verbunden ist, die bereitgestellt werden muß. Vor allem miniaturisierte portable Sende- und Empfangsgeräte müssen einen möglichst niedrigen Strombedarf haben, um möglichst lange Betriebszeiten ohne Wechsel der Batterien bzw. Nachladen der Akkus zu erreichen.

Schließlich ist jede zusätzliche Komponente eines derartigen Regelkreises auch mit einem bestimmten Platzbedarf verbunden, so daß der Platzbedarf mit einer zunehmenden Anzahl zu erzeugender Frequenzen mit einem linearen Anstieg des Platzbedarfs verbunden ist.

Aus der DE-A-30 46 486 ist es bekannt, eine Oszillatoreinrichtung zur Generierung einer Nutzfrequenz mit Hilfe von zwei Oszillatoren auszubilden, bei denen am Eingang des einen Oszillators die Nutzfrequenz abgreifbar ist und bei der der andere Oszillator eine Hilfsfrequenz generiert, mit deren Hilfe der Rauschanteil des Nutzsignales reduziert wird. Es ist eine gemeinsame Referenzfrequenz vorgesehen, die über separate Phasendiskriminatoren in Spannungen gewandelt wird. Die Spannungen werden Integratoren zur Ansteuerung der Oszillatoren zugeführt. Es sind insgesamt drei Frequenzteiler vorgesehen, bei denen die Teilungsverhältnisse des ersten und des zweiten Frequenzteilers in einem vorgebbaren Verhältnis stehen. Dieses Verhältnis wird dadurch bestimmt, daß das Teilungsverhältnis des zweiten Frequenzteilers gleich dem Teilungsverhältnis des ersten Frequenzteilers zuzüglich einer ganzen Zahl ist. Diese ganze Zahl ist eine Konstante, die keine Abhängigkeit von den Teilungsverhältnissen der beiden Frequenzteiler aufweist. Es wird eine Mischstufe verwendet, um die Summe bzw. die Differenz von zwei hochfrequenten Signalen zu generieren. Insbesondere ist kein digitaler Addierer zur Einstellung der Teilerverhältnisse vorgesehen.

Aus der Zeitschrift Elektronik, Band 31, Nr. 1, 15. Januar 1982, Seite 69 und 70, München, DE, ist es bekannt, mehrere PLL-Schaltungen zu verwenden, die von einem einzigen Referenzoszillator angesteuert und mit fest vorgegebenen Teilerverhältnissen betrieben werden. Hierdurch besteht keine Möglichkeit, zur Beeinflussung der Ausgangssignale auf die Teilerverhältnisse einzuwirken.

Aus der US-A-3 962 653 ist es bekannt, eine Vorrichtung zur Erzeugung von zwei unterschiedlichen Frequenzen derart auszubilden, daß zwei PLL-Schaltungen mit Hilfe einer digitalen Einrichtung so gesteuert werden, daß die jeweiligen Signal frequenzen vorgebbare Werte haben. Es werden dort allerdings nicht Addierschaltungen, sondern Mischstufen verwendet, um die Signale miteinander zu verknüpfen. Mit Hilfe dieser Vorrichtung können Signale bereitgestellt werden, deren Frequenzen komplementär zu einer Bezugsfrequenz sind.

In der GB-A-21 13 493 wird eine Vorrichtung beschrieben, mit deren Hilfe ein einzelnes frequenzmoduliertes Signal generiert werden kann. Zur Reduzierung eines Rauschanteiles sind mehrere Teiler vorgesehen. Gemäß dieser Druckschrift ist es möglich, einstellbare Teiler zu verwenden. Es wird jedoch nicht angegeben, wie eine Verwendung derartiger Teiler im Bereich von Oszillatoreinrichtungen zur Generierung von mehreren Nutzsignalen zu erfolgen hat.

Es ist Aufgabe der vorliegenden Erfindung eine Oszillatoreinrichtung für die Erzeugung zweier oder mehrerer Frequenzen zu schaffen, die bei einem verminderten Schaltungsaufwand mit einer geringeren Stromaufnahme gegenüber herkömmlichen vergleichbaren Oszillatoreinrichtungen auskommt. die gegenüber diesen einen verminderten Platzbedarf erfordert und die zudem einfach im Aufbau ist und sich grundsätzlich auch zur schaltungsmäßigen Integration, beispielsweise in Form eines integrierten Bausteins eignet.

Gelöst wird die Aufgabe gemäß der Erfindung dadurch, daß

- den Phasendetektoren beider Phasenregelkreise PLL das gleiche Referenzsignal zugeführt wird, das in einem einzigen Frequenzsignalteiler erzeugt wird, der von einem Referenzoszillator angesteuert wird, daß
- die Teilungsverhältnisse aller Teiler einstellbar sind, und daß
- die Summation der Teilungsverhältnisse $n_1$, $n_2$ über einen Addierer erfolgt.

Der Vorteil einer derartigen Schaltungsanordnung liegt im wesentlichen darin, daß im Gegensatz zu der bisher nötigen gesonderten Teilung des Referenzsignals vom Referenzoszillator, die entsprechend einer gewünschten Frequenz des Regelkreises in einem Teiler pro Regelkreis zugeführt werden mußte, erfindungsgemäß nur noch ein einziges Referenzsignal beiden oder mehreren Phasenregelkreisen zugeführt zu werden braucht.

Vorteilhafterweise wird das Referenzsignal mit einem einzigen Referenzsignalteiler erzeugt, der von einem Referenzoszillator angesteuert wird. Wie schon erwähnt, wurden bisher pro Regelkreis mit einer bestimmten gewünschten Frequenz ein gesonderter Teiler benötigt, wohingegen gemäß dieser Ausführungsform der Erfindung ein einziger Teiler zwei oder mehrere Regelstufen gemeinsam mit dem heruntergeteilten Referenzsignal versorgt. Darüber hinaus ist vorgesehen, daß das von den mit den abstimmbaren Oszillatoren VCO verbundenen Teilern der Phasenregelkreise PLL erzeugte Teilungsverhältnis n der von den abstimmbaren Oszillatoren VCO gelieferten Signale vorbestimmter Frequenz derart einstellbar ist, daß das Teilungsverhältnis n des einen Teilers gegenüber dem anderen Teiler $n_1$ : $n = n_1 + n_2$ beträgt. Diese Ausgestaltung der Oszillatoreinrichtung hat den Vorteil, daß eine feste Differenz zwischen den Frequenzen, die von den Oszillatoren über die Teiler geliefert werden, sich in einem festen vorbestimmten Verhältnis befindet. Diese Ausgestaltung hat darüber hinaus den Vorteil, daß die Teilungsverhältnisse auf einfache Weise variiert werden können, so daß zu einem festen vorgegebenen Teilungsverhältnis lediglich ein variables Teilungsverhältnis addiert zu werden braucht, um beide Regelkreise gemäß der vorangehenden Relation mit einem bestimmten Teilungsverhältnis die Frequenz für den Vergleich im Phasendetektor herunterteilen zu lassen.

Es ist schließlich vorteilhaft, die Einstellbarkeit der Teiler der Oszillatoreinrichtung entweder aller oder bestimmter Teiler mittels einem mit den Teilern über Datenleitungen verbundenen Rechner erfolgen zu lassen, wobei der Rechner beispielsweise ein Mikroprozessor sein kann. Auf diese Weise lassen sich die Frequenzen bei der erfindungsgemäßen Oszillatoreinrichtung variabel und schnell steuern.

Die Erfindung wird nun unter Bezugnahme auf die nachfolgenden schematischen Zeichnungen anhand mehrerer Ausführungsbeispiele eingehend beschrieben. Darin zeigen:

Fig. 1    den prinzipiellen bisherigen Aufbau einer Oszillatoreinrichtung im Blockschaltbild,

Fig. 2    den Aufbau der beiden Phasenregelkreise gemäß Fig. 1 im Blockschaltbild,

Fig. 3    den Aufbau der Phasenregelkreise der erfindungsgemäßen Oszillatoreinrichtung im Blockschaltbild und

Fig. 4    einen modifizierten Aufbau der Phasenregelkreise der erfindungsgemäßen Oszillatoreinrichtung im Blockschaltbild.

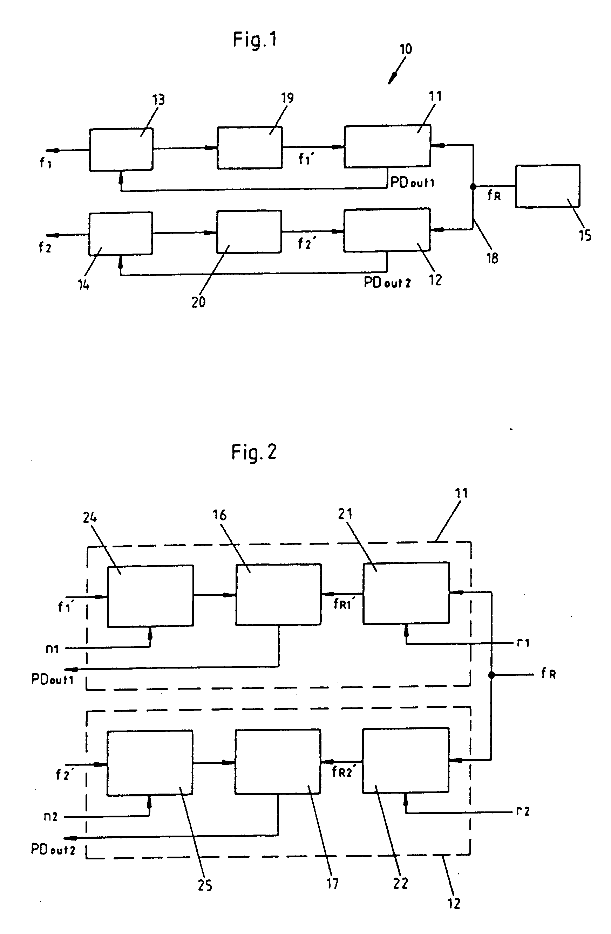

Die in Fig. 1 dargestellte Oszillatoreinrichtung 10, die einen bisher verwendeten prinzipiellen Aufbau darstellt, liefert zwei Frequenzen $f_1$ und $f_2$, stellt also eine Oszillatoreinrichtung dar, die zwei unterschiedliche Frequenzen liefert. Es sei darauf hingewiesen, daß die Oszillatoreinrichtung 10 gemäß der Erfindung prinzipiell eine beliebige Zahl von Frequenzen $f_n$ durch Hinzufügen weiterer Regelkreise zu generieren gestattet, ohne daß das Wesen der Erfindung verlassen wird. Lediglich zum Zwecke der vereinfachten Darstellung wird im folgenden die Oszillatoreinrichtung 10 lediglich im Zusammenhang mit der Generierung zweier Frequenzen $f_1$ und $f_2$ beschrieben.

Ein Regelkreis der Oszillatoreinrichtung 10 besteht auf bekannte Weise aus einem Referenzoszillator 15, der einem Phasenregelkreis PLL 11 ein bestimmtes Referenzfrequenzsignal $f_R$ liefert. Im Phasenregelkreis 11 ist ein Phasendetektor 16 vorhanden, vgl. Fig. 2, der das vom Referenzoszillator 15 kommende Referenzsignal $f_R$ mit einem Frequenzsignal $f'_1$ vergleicht, das von einem abstimmbaren Oszillator 13 geliefert wird, der auch als VCO (Voltage Controlled Oscillator) bezeichnet wird. Am Ausgang des abstimmbaren Oszillators 13 wird das Oszillatorausgangssignal $f_1$ zur Verwendung in einem Empfänger oder Sender ausgegeben. Das Ausgangssignal $f_1$ des abstimmbaren Oszillators 13 wird ebenfalls einem Vorteiler 19 zugeführt, der das Signal $f_1$ auf das zuvor schon erwähnte Signal $f'_1$ herunterteilt.

Entsprechend der vom Phasendetektor 16 erkannten Phasendifferenz zwischen dem im Teiler 24 durch das Teilungsverhältnis $n_1$ geteilten Frequenzsignal $f'_1$ und dem im Teiler 21 durch das Teilungsverhältnis $r_1$ geteilten Referenzsignal $f_R$ mit dem Bezugszeichen 18 wird eine Spannung $PD_{out1}$ erzeugt und auf einen Regeleingang des abstimmbaren Oszillators 13 gegeben. Entsprechend der erkannten Phasendifferenz ist das Ausgangssignal bzw. die Ausgangsregelspannung $PD_{out1}$ mehr oder weniger groß, so daß der abstimmbare spannungsgesteuerte Oszillator 13 fortwährend nachgeregelt wird und somit auf hochkonstante Weise seine Ausgangsfrequenz $f_1$ liefert.

Wie aus Fig. 1 ersichtlich ist, ist der zweite Regelkreis der Oszillatoreinrichtung 10, der die zweite Ausgangsfrequenz $f_2$ liefert, identisch zum voranbeschriebenen Regelkreis, der die Frequenz $f_1$ liefert, aufgebaut. Beide Regelkreise werden gemeinsam vom Referenzoszillator 15 mit dem Referenzsignal 18 versorgt.

Wie aus Fig. 2 ersichtlich ist, ist jeder Phasenregelkreis 11, 12 bisher mit je einem Teiler 21, 22 für das Referenzsignal $f_R$ mit dem Bezugszeichen 18, das vom Referenzoszillator 15 geliefert wird, versehen. Die Ausgänge der Teiler 21, 22 liefern nach erfolgter Teilung die geteilten Referenzsignale $f'_{R1}$ und $f'_{R2}$ jeweils an die Phasendetektoren 16, 17.

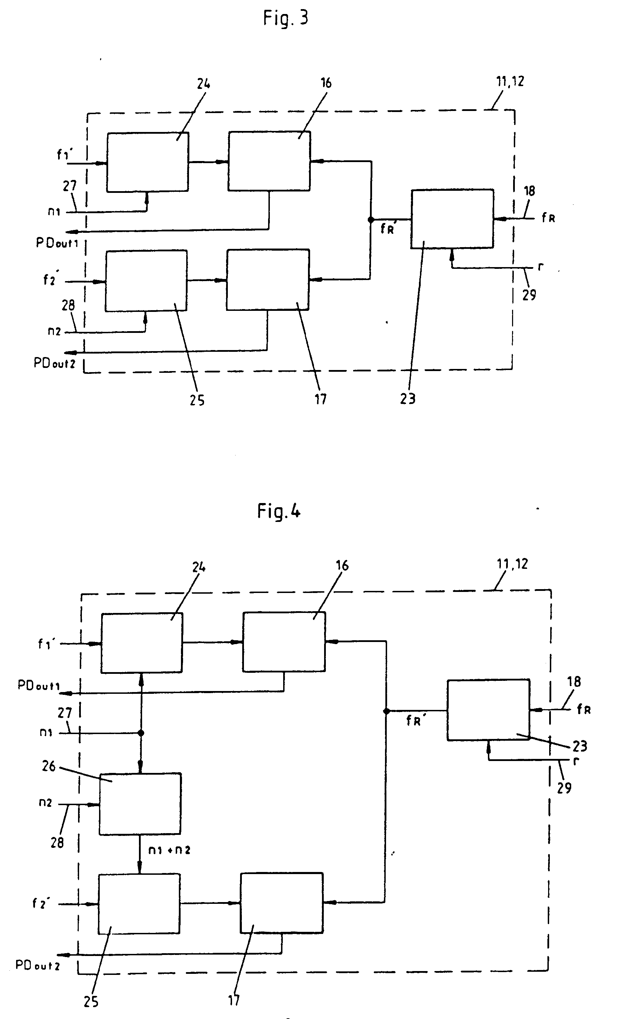

Bei der erfindungsgemäßen Oszillatoreinrichtung 10, wie sie in Fig. 3 dargestellt ist, sind anstelle von zwei Teilern 21, 22, die für jeden Regelkreis zur Erzeugung vorbestimmter Frequenzen $f_1$ und $f_2$ vorgesehen sind, ein gemeinsamer Referenzsignalteiler 23 vorgesehen, der an beide Phasendetektoren 16, 17 ein gemeinsames geteiltes Referenzsignal $f_R$ liefert. Dadurch wird der Strombedarf der gesamten Schaltungsanordnung erheblich geringer, da bei einer beliebigen Zahl von Regelkreisen zur Erzeugung vorbestimmter Frequenzen $f_n$ nur ein einziger Referenzsignalteiler 23 vorgesehen zu werden braucht.

Die erfindungsgemäße Oszillatoreinrichtung gestattet darüber hinaus auch die Integration der gesamten Baugruppen, beispielsweise in Form eines integrierten Schaltkreises.

Die in Fig. 4 dargestellte Ausführungsform der Oszillatoreinrichtung 10 ist dann vorteilhaft, wenn eine feste Differenz zwischen den Frequenzen $f'_1$ und $f'_2$ benötigt wird. Wie schon erwähnt, stammen die Frequenzsignale $f'_1$ und $f'_2$ von den beiden Vorteilern 19, 20 und werden in den Teilern 24 und 25 der Phasenregelkreise 11, 12 nochmals heruntergeteilt und den Phasendetektoren 16, 17 zum Vergleich mit dem Referenzsignal $f_R$ zugeführt. Das Teilungsverhältnis $n_1$ des Teilers 24 wird nun in einem Addierer 26 mit einem Teilungsverhältnis $n_2$ addiert. Dieses addierte Teilungsverhältnis $n_1 + n_2$ wird dem Teiler 25 zugeführt. Das Teilungsverhältnis $n_2$ bestimmt somit die Differenz der beiden Frequenzen $f'_1$ und $f'_2$, die von den abstimmbaren Oszillatoren 13, 14 geliefert werden.

Wie in den Fig. 2, 3 und 4 dargestellt, können die Teilungsverhältnisse $n_1$, $n_2$ sowie das Teilungsverhältnis r des Referenzsignalteilers 23 durch äußere Beschaltung, d. h. im dargestellten Fall über Datenleitungen 27, 28, 29 eingestellt werden, beispielsweise mittels eines hier nicht dargestellten Rechners, der vorzugsweise ein Mikroprozessor sein kann. Auf diese Weise lassen sich unterschiedliche Frequenzen $f_n$ bei der Oszillatoreinrichtung 10 beliebig einstellen.

**Patentansprüche**

1.    Oszillatoreinrichtung zur Erzeugung von wenigstens zwei unterschiedlichen Frequenzen mit wenigstens zwei getrennten Phasenregelkreisen PLL (11, 12) und jeweils mit den Phasenregelkreisen (11, 12) in Regelschleifen verbundenen abstimmbaren Oszillatoren VCO (13, 14), wobei
- ein aus einer festen Referenzfrequenz durch Frequenzteilung erzeugtes Referenzsignal (18) Phasendetektoren (16, 17) der Phasenregelkreise zugeführt wird, und
- das von den mit den abstimmbaren Oszillatoren VCO (13, 14) verbundenen Teilern (24, 25) der Phasenregelkreise PLL (11, 12) erzeugte Teilungsverhältnis der von den abstimmbaren Oszillatoren VCO (13, 14) gelieferten Signale vorbestimmter Frequenz derart einstellbar ist, daß das Teilungsverhältnis n des einen Teilers (25) zum Teilungsverhältnis $n_1$ des anderen Teilers (24) in folgendem Zusammenhang steht:

$$n = n_1 + n_2,$$

wobei $n_2$ die Differenz der von den abstimmbaren Oszillatoren gelieferten Frequenzen bestimmt, dadurch gekennzeichnet, daß

- den Phasendetektoren (16, 17) beider Phasenregelkreise PLL (11, 12) das gleiche Referenzsignal (18) zugeführt wird, das in einem einzigen Frequenzsignalteiler erzeugt wird, der von einem Referenzoszillator angesteuert wird, daß
- die Teilungsverhältnisse aller Teiler einstellbar sind, und daß
- die Summation der Teilungsverhältnisse $n_1$, $n_2$ über einen Addierer erfolgt.

2. Oszillatoreinrichtung nach Anspruch 1, dadurch gekennzeichnet, daß die Teilungsverhältnisse der Teiler (24, 25; 23) mittels eines über Datenleitungen (27, 28; 29) angeschlossenen Rechners eingestellt werden.

## Claims

1. Oscillator device for generating at least two different frequencies, having at least two separate phase-locked loop circuits PLL (11, 12) and having in each case tunable oscillators VCO (13, 14) connected in control loops to the phase-locked loop circuits (11, 12),
   - a reference signal (18) generated from a fixed reference frequency by frequency division being fed to phase detectors (16, 17) of the phase-locked loops, and
   - the division ratio of the signals of predetermined frequency delivered by the tunable oscillators VCO (13, 14), which division ratio is generated by the dividers (24, 25), connected to the tunable oscillators VCO (13, 14), of the phase-locked loops PLL (11, 12) being adjustable in such a way that the division ratio n of one divider (25) is in the following relationship to the division ratio $n_1$ of the other divider (24):

$$n = n_1 + n_2,$$

   where $n_2$ determines the difference in the frequencies delivered by the tunable oscillators, characterized in that
   - there is fed to the phase detectors (16, 17) of the two phase-locked loop circuits PLL (11, 12) the same reference signal (18) as is generated in a single frequency-signal divider which is driven by a reference oscillator, in that
   - the division ratio of all the dividers is adjustable, and in that
   - the division ratios $n_1$, $n_2$ are summed by means of an adder.

2. Oscillator device according to claim 1, characterised in that the division ratios of the dividers (24, 25; 23) are set by means of a computer connected via data lines (27, 28; 29).

## Revendications

1. Dispositif oscillateur pour la génération d'au moins deux fréquences différentes à l'aide d'au moins deux circuits de réglage de phase (PLL) séparés (11, 12) et de deux oscillateurs à fréquence réglable (VCO) (13, 14) insérés avec les circuits de réglage de phase dans des boucles de régulation dans lesquelles
   - un signal de référence (18), dérivé par division de fréquence d'une fréquence de référence fixe, est appliqué aux détecteurs de phase (16, 17) des circuits de régulation de phase, et
   - que le rapport de division des diviseurs (24 ,25) des circuits de régulation de phase PLL (11, 12), raccordés aux oscillateurs à fréquence réglable VCO (13, 14), ledit rapport de division des signaux étant de fréquence prédéterminée, fournis par lesdits oscillateurs à fréquence réglable VCO (13, 14), est réglable de telle façon que le rapport de division n du premier diviseur (25) se rapporte au rapport de division $n_1$ de l'autre diviseur (24) selon l'équation :

$$n = n1 + n2,$$

   dans laquelle n2 détermine la différence entre les fréquences fournies par les oscillateurs à fréquence réglable,
   caractérisé en ce que
   - le même signal de référence (18) généré dans un diviseur de fréquence unique dont le signal d'entrée est fourni par un oscillateur de référence, est appliqué aux détecteurs de phase (16, 17) des deux circuits de réglage de phase PLL (11, 12) de sorte que
- les rapports de division de tous les diviseurs sont réglables et que
- la sommation des rapports de division n1, n2 est obtenue au moyen d'un circuit d'addition.

2. Dispositif oscillateur selon la revendication 1, caractérisé en ce que les rapports de division des diviseurs (24, 25, 23) sont sélectionnés au moyen de circuits de transmission de données d'un ordinateur.

## Fig. 1

## Fig. 2

## Fig. 3

## Fig. 4

8